(19) **Europäisches Patentamt**

**European Patent Office**

**Office européen des brevets**

(11) Veröffentlichungsnummer: **0 348 785**

**A2**

(12) **EUROPÄISCHE PATENTANMELDUNG**

(21) Anmeldenummer: **89111119.7**

(22) Anmeldetag: **19.06.89**

(51) Int. Cl.⁴: **H01J 37/26 , H01J 37/04 , G01R 31/305**

(30) Priorität: **27.06.88 DE 3821643**

(43) Veröffentlichungstag der Anmeldung:
**03.01.90 Patentblatt 90/01**

(84) Benannte Vertragsstaaten:
**DE FR GB NL**

(71) Anmelder: **Siemens Aktiengesellschaft**
**Wittelsbacherplatz 2**
**D-8000 München 2(DE)**

(72) Erfinder: **Plies, Erich, Dr. rer. nat.**
**Firlestrasse 15**
**D-8000 München 83(DE)**
Erfinder: **Otto, Johann, Dipl.-Ing. (FH)**
**Pater-Hammerschid-Strasse 4**
**D-8170 Bad Tölz(DE)**

(54) **Elektronenstrahlmessgerät.**

(57) Konventionelle Strahlaustastsysteme sind in der Lage, Elektronenimpulse mit einer minimalen Breite von etwa 100 bis 200 ps zu erzeugen. Eine Verringerung der Impulsbreite auf einige 10 Pikosekunden ist zwar prinzipiell möglich, würde aber aufgrund der damit einhergehenden Verringerung des Sondenstromes zu einer erheblichen Verlängerung der Meßzeiten führen. Es wird deshalb vorgeschlagen, eine von einem gepulsten Laserstrahl (LA) beaufschlagte Photokathode (PK) zusätzlich an die Säule eines Elektronenstrahlmeßgerätes anzuflanschen und die Photoelektronenquelle mit Hilfe einer fokussierenden Ablenkeinheit (SFM) stigmatisch auf die Strahlachse (OA1) abzubilden. Als fokussierende Ablenkeinheit (SFM) kommt insbesondere ein Sektorfeldmagnet in Betracht.

FIG 4

EP 0 348 785 A2

## Elektronenstrahlmeßgerät

Die Erfindung bezieht sich auf ein Elektronenstrahlmeßgerät nach dem Oberbegriff des Patentanspruchs 1.

Aus Microelectronic Engineering, Vol. 7 (1987), Seiten 163 bis 172 ist ein für niedrige Beschleunigungsspannungen von 0,5 -2,5 kV optimiertes Elektronenstrahlmeßgerät bekannt, mit dem man die Potentialverteilung in Bauelementen der Mikroelektronik mit einer Ortsauflösung von etwa 0,1 $\mu$m abtasten und den Potentialverlauf an bis zu 0,5 $\mu$m breiten Leiterbahnen mit einer durch das konventionelle Strahlaustastsystem vorgegebenen Zeitauflösung von etwa 100 - 200 Ps stroboskopisch aufzeichnen kann.

Aus Appl. Phys. Lett. 51 (2), 1987, Seiten 145 bis 147 ist ein Rasterelektronenmikroskop bekannt, dessen thermischer LaB$_6$-bzw. Feldemissionsstrahler durch eine mit einem gepulsten Laserstrahl (Impulswiederholfrequenz = 100 MHz, Impulsbreite = 1 - 2 ps) beaufschlagte Photokathode ersetzt wurde. Da die Breite der erzeugten Photoelektronenimpulse etwa der Breite der die Photoemission auslösenden Laserimpulse entspricht, ist dieses System insbesondere für stroboskopische Messungen in schnellen Gallium-Arsenid-Schaltungen mit einer im Pikosekundenbereich liegenden Zeitauflösung geeignet. Die Ortsauflösung entspricht etwa der des Rasterelektronenmikroskops mit einem konventionellen Strahlerzeuger.

Aus Microelectronic Engineering, Vol. 4, No. 2 (1986) Seiten 77 bis 106 sind Verfahren zur Abbildung der Potentialverteilung in VLSI-Schaltungen bekannt, die einen kontinuierlichen Elektronenstrahl bzw. einen gepulsten Elektronenstrahl mit einer vergleichsweise niedrigen, insbesondere variablen Impulswiederholfrequenz($f_p \approx$ 1 - 10 MHz) erfordern. Diese für die schnelle Überprüfung der Funktionsweise mikroelektronischer Bauelemente unverzichtbaren Verfahren können mit dem bekannten Elektronenstrahlmeßgerät aufgrund der durch das Lasersystem fest vorgegebenen Impulswiederholfrequenz nur schlecht durchgeführt werden.

Der Erfindung liegt die Aufgabe zugrunde, ein Elektronenstrahlmeßgerät der eingangs genannten Art anzugeben, mit dem sowohl abbildende Verfahren als auch Messungen des Potentialverlaufs mit einer hohen Orts- und Zeitauflösung durchgeführt werden können. Diese Aufgabe wird erfindungsgemäß durch ein Elektronenstrahlmeßgerät nach Patentanspruch 1 gelöst. Die Unteransprüche betreffen vorteilhafte Weiterbildungen der Erfindung.

Der mit der Erfindung erzielbare Vorteil besteht insbesondere darin, daß in einem Elektronenstrahlmeßgerät sowohl abbildende Verfahren als auch Messungen des Potentialverlaufs an Leiterbahnen schneller hochintegrierter Schaltungen mit einer im Picosekundenbereich liegenden Zeitauflösung durchgeführt werden können.

Die Erfindung wird im folgenden anhand der Zeichnungen näher erläutert. Hierbei zeigt:

Figur 1 den schematischen Aufbau eines bekannten Elektronenstrahlmeßgeräts,

Figur 2 ein erstes Ausführungsbeispiel eines erfindungsgemäßen Elektronenstrahlmeßgeräts,

Figur 3 den schematischen Aufbau einer fokussierenden Ablenkeinheit,

Figur 4 ein zweites Ausführungsbeispiel eines erfindungsgemäßen Elektronenstrahlmeßgeräts,

Figur 5 und 6 eine Einrichtung zur Korrektur der Verzeichnung des Sektorfeldmagneten,

Figur 7 einen Stigmator zur teilweisen Korrektur der Öffnungs fehler des Sektorfeldmagneten,

Figur 8 die Potentialverhältnisse innerhalb eines erfindungsgemäßen Elektronenstrahlmeßgerätes und

Figur 9 eine Vorrichtung zur Verschiebung der Photokathode im Laserstrahl.

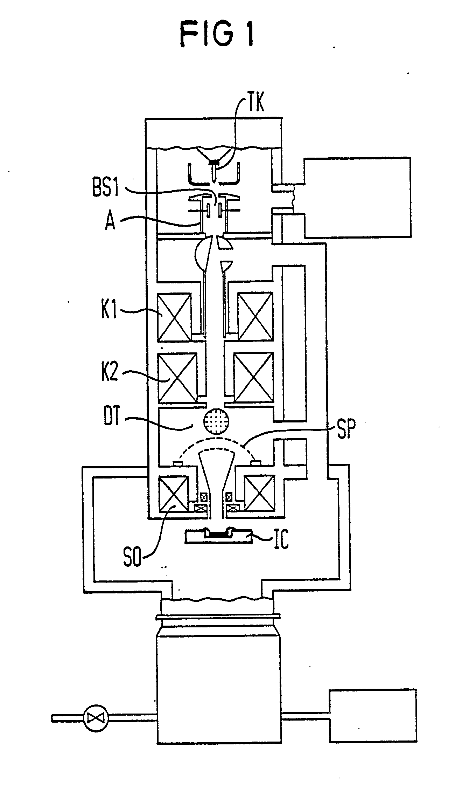

Die in Figur 1 schematisch dargestellte Säule des aus Microelectronic Engineering bekannten Elektronenstrahlmeßgerätes (ICT E-Beam Testing System 9000) besteht aus einem konventionellen Strahlerzeuger mit einer auf der optischen Achse zentriert angeordneten LaB$_6$-Kathode TK, einem in die Anode A des Strahlerzeugers integrierten Strahlaustastsystem BS1, einem aus einer magnetischen Linse und einer elektrostatischen Zweirohrlinse bestehenden Immersionskondensor K1, einer zweiten Kondensorlinse K2 und einer Objektlinse SO zur Fokussierung der Primärelektronen auf das in der evakuierten Probenkammer angeordnete Bauelement IC. Die aus einer kurzbrennweitigen magnetischen Linse, einer Ablenkeinheit, einem Stigmator und einem Spektrometer SP bestehende Objektivlinse SO bildet die Komponente der elektronenoptischen Säule, mit der man sowohl die im Immersionskondensor K1 auf die gewünschte Endenergie von beispielsweise 1 keV abgebremsten Primärelektronen als auch die an der Meßstelle ausgelösten Sekundärelektronen in jeweils einen auf der optischen Achse liegenden Punkt abbildet. Der Fokus der im Feld einer Absaugelektrode beschleunigten Sekundärelektronen liegt hierbei im Zentrum eines kugelsymmetrischen elektrischen Gegenfeldes, das man in einem oberhalb des Objektivlinsenkörpers angeordneten Spektrometerteil zwischen zwei entsprechend geformten Elektroden aufbaut. Sekundärelektronen mit Energien oberhalb der durch das Spektrometerfeld vorgegebenen Mindestenergie werden in zwei symmetrisch zur Strahlachse angeordneten Detektoren DT nachgewiesen.

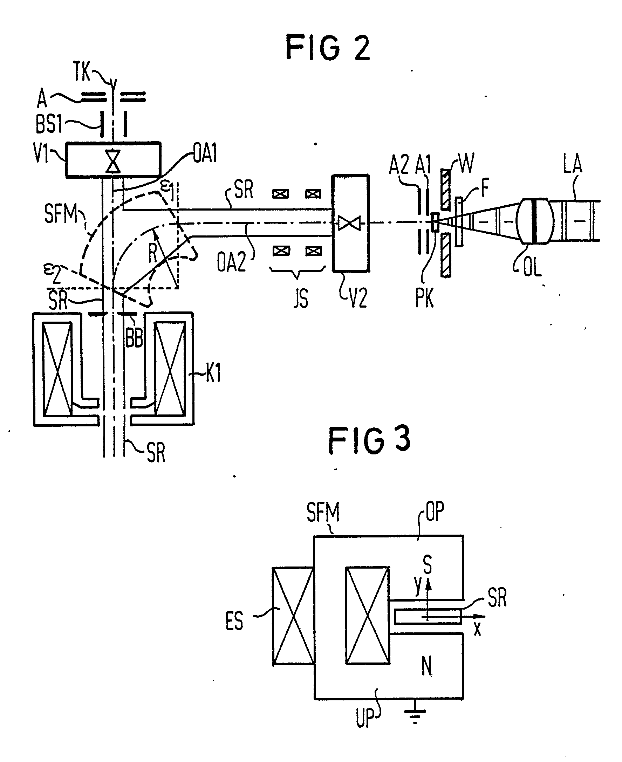

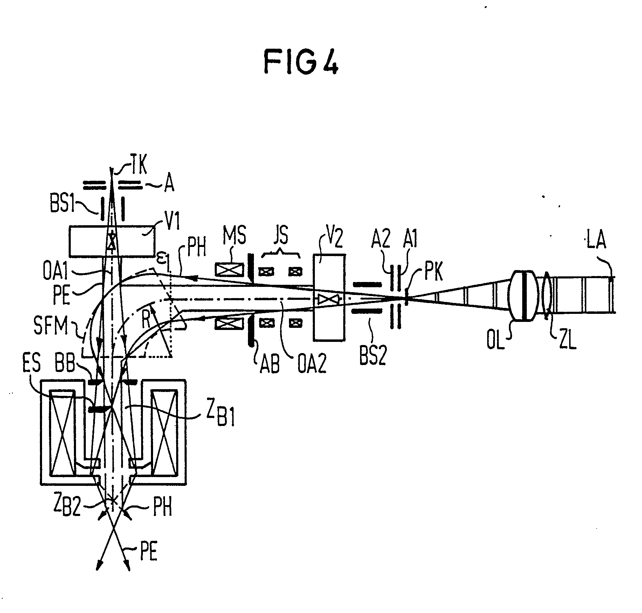

Das konventionelle Strahlaustastsystem BS1 (Plattenkondensator) ist in der Lage, Elektronenimpulse mit einer minimalen Breite von etwa 100 - 200 ps zu erzeugen, wobei die maximale Impulswiederholfrequenz bei etwa 10 MHz liegt. Eine Verringerung der Impulsbreite auf einige 10 ps ist zwar prinzipiell möglich, würde aber aufgrund der damit einhergehenden Verringerung des Sondenstromes zu einer erheblichen Verlängerung der Meßzeiten führen. Erfindungsgemäß wird deshalb vorgeschlagen, den in Figur 2 schematisch dargestellten Photoelektronenstrahler seitlich an die Säule des bekannten Elektronenstrahlmeßgeräts anzuflanschen und die Photoelektronenquelle mit Hilfe einer fokussierenden Ablenkeinheit SFM stigmatisch auf die Strahlachse OA1 abzubilden (siehe auch Figur 4, in der sowohl die Bahnen der von der LaB₆-Kathode TK emittierten thermischen Elektronen PE als auch die Bahnen der vom Laserstrahl LA auf der Photokathode PK ausgelösten Photoelektronen PH dargestellt sind).

Der Photoelektronenstrahler besteht aus einer von einem gepulsten Laserstrahl LA beaufschlagten Photokathode PK und einem Elektrodensystem A1, A2 (Doppelanode) zur Beschleunigung der in einer 100 - 200 Å dicken Edelmetall- oder Alkalimetallschicht ausgelösten Photoelektronen PH in Richtung eines zweistufigen magnetischen Justiersystems JS. Er ist ebenso wie der konventionelle Strahlerzeuger in einer Kammer angeordnet, wobei ein Ventil V2 das in der Kammer erzeugte Hochvakuum ($P_K \leq$ x 10 (- 5) Pa) von dem im Strahlrohr SR aufgebauten Vakuum ($P_{SR} \leq$ 2 x 10 (-4) Pa) trennt. In der rückseitigen Kammerwand W ist ein Fenster F vorhanden, durch das man den Laserstrahl LA mit Hilfe einer stark verkleinernden Linse OL auf das auf einem Glasträger TR aufgebrachte Photokathodenmaterial PKM (Au, Na, K, Rb, Cs) abbildet (siehe auch Figur 9). Für die Ablenkung und Fokussierung der impulsförmig ausgelösten Photoelektronen PH (Impulswiederholfrequenz ≈ 10 - 200 MHz, Impulsbreite ≈ 2 - 5 ps) ist ein in Figur 3 dargestellter, aus einer Erregerspule ES, einem oberen und einem unteren Polschuh OP bzw. UP bestehender Sektorfeldmagnet SFM vorgesehen. In diesem zwischen dem konventionellen Strahlerzeuger TK/A und dem Immersionskondensor K1 angeordneten Ablenkelement (Krümmungsradius R ≈ 25 mm) baut sich ein homogenes magnetisches Sektorfeld mit einer quellenseitig (Photoelektronenquelle) geneigten Feldgrenze auf. Der von der Normalen auf der quellenseitigen Feldbegrenzungsebene und der Strahlachse OA2 eingeschlossene Winkel $\epsilon_1 > 0$ wird hierbei durch die Polschuhgeometrie derart eingestellt, daß eine stigmatische Abbildung der Photoelektronenquelle stattfindet.

Um eine Verzeichnung 1. Ordnung des auf der Strahlachse OA1 oberhalb des Immersionskondensors K1 liegenden Zwischenbildes $Z_{B1}$ (siehe Figur 4) der Photoelektronenquelle zu vermeiden, ist es notwendig, auch die probenseitige Grenze des magnetischen Sektorfeldes durch die Polschuhform derart vorzugeben, daß die Normale auf der probenseitigen Feldbegrenzungsebene einen Winkel $\epsilon_2 > 0$ mit der Achse OA1 des Elektronenstrahlmeßgerätes einschließt.

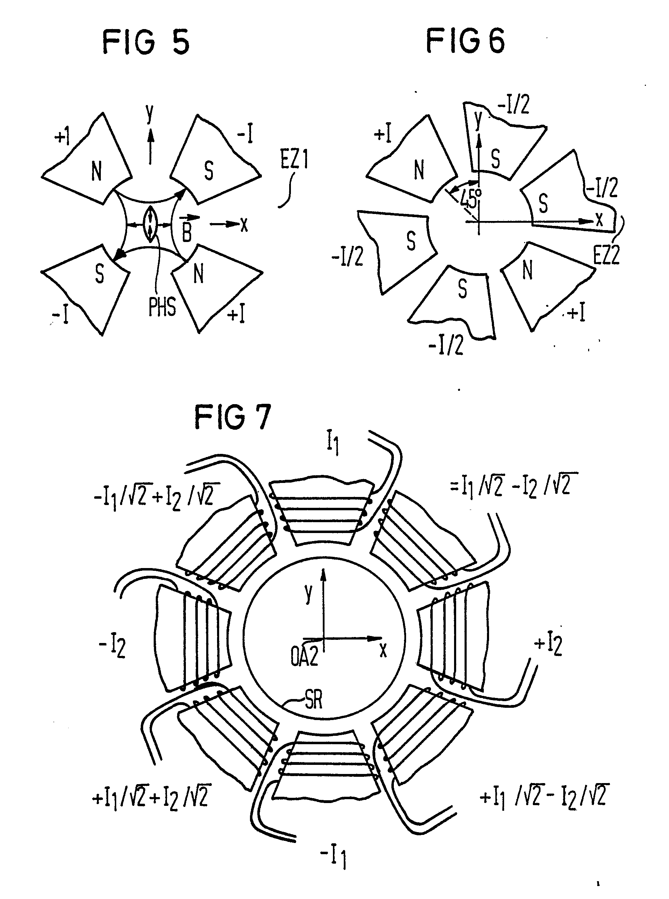

Kann man aus Platzgründen nur einen Sektorfeldmagneten mit $\epsilon_2 = 0$ in die Säule einbauen (siehe Figur 4), so muß dessen Verzeichnung erster Ordnung beispielsweise mit Hilfe eines im Zwischenbild $z_{B1}$ der Photoelektronenquelle angeordneten Entzerrers korrigiert werden. Als Entzerrer kommen hierbei insbesondere die in den Figuren 5 und 6 schematisch dargestellten 4- oder 6-Polelemente EZ1 bzw.EZ2 in Betracht, deren magnetisches Quadrupolfeld B die im Zwischenbild $z_{B1}$ elliptisch verzeichnete Photoelektronensonde PHS in Richtung der Pfeile so deformiert, daß der Sondenquerschnitt in dem vom Immersionskondensor K1 erzeugten Zwischenbild $z_{B2}$ wieder rotationssymmetrisch ist.

Die Verzeichnung des magnetischen Sektorfeldes ist auch dadurch korrigierbar, daß man anstelle eines kreisförmigen einen elliptischen Laserstrahlfleck auf der Photokathode PK erzeugt. Dies kann durch eine in den Beleuchtungsstrahlengang des Lasers eingebrachte Zylinderlinse ZL oder durch einen schräg auf die Photokathode PK auftreffenden Laserstrahl LA erreicht werden. Der von der Laserstrahlachse und der Normalen auf der Photokathodeoberfläche eingeschlossene Winkel ist hierbei so zu wählen, daß

$$a/b = V_x/V_y$$

gilt, wobei a die große Hauptachse des elliptischen Laserstrahlflecks in x-Richtung, b dessen kleine Hauptachse, $V_x$ die Vergrößerung des Sektorfeldmagneten SFM im x-z-Schnitt (Ablenkebene) und $V_Y$ dessen Vergrößerung im y-z-Schnitt bezeichnet ($|V_x| < |V_y|$).

Der Sektorfeldmagnet SFM besitzt wie jedes abbildende System einen Öffnungsfehler, den man zumindest teilweise durch einen im Strahlengang vor der Ablenkeinheit angeordneten justierbaren magnetischen Stigmator MS korrigieren kann. Als Stigmator MS kommt insbesondere das in Figur 7 schematisch dargestellte 8-Polelement in Betracht, das außer einem drehbaren Dipolfeld (Strahlablenkung) und einem drehbaren zweizähligen Quadrupolfeld (Korrektur des Astigmatismus 1. Ordnung) auch zwei überlagerte Hexapolfelder (teilweise Korrektur des Öffnungsfehlers 2. Ordnung) der Form

$$B_x = 2C_1 \cdot x \cdot y + C_2 \cdot (x^2 - y^2)$$

$B_y = C_1 \cdot (x^2 - y^2) - 2 C_2 \cdot x \cdot y$

im Strahlrohr SR erzeugt. Für die Konstanten $C_1$ und $C_2$ gilt hierbei die Beziehung

$C_1 \sim I_1$

$C_2 \sim I_2$

wobei $I_1$ und $I_2$ die in den Erregerwicklungen fließenden Ströme bezeichnen. Der Öffnungsfehler kann auch durch eine im Strahlengang vor dem Sektorfeldmagnet SFM, insbesondere vor dem Stigmator MS angeordnete Aperturblende AB (Lochdurchmesser ca. 200 μm bis 1 mm) erheblich reduziert werden.

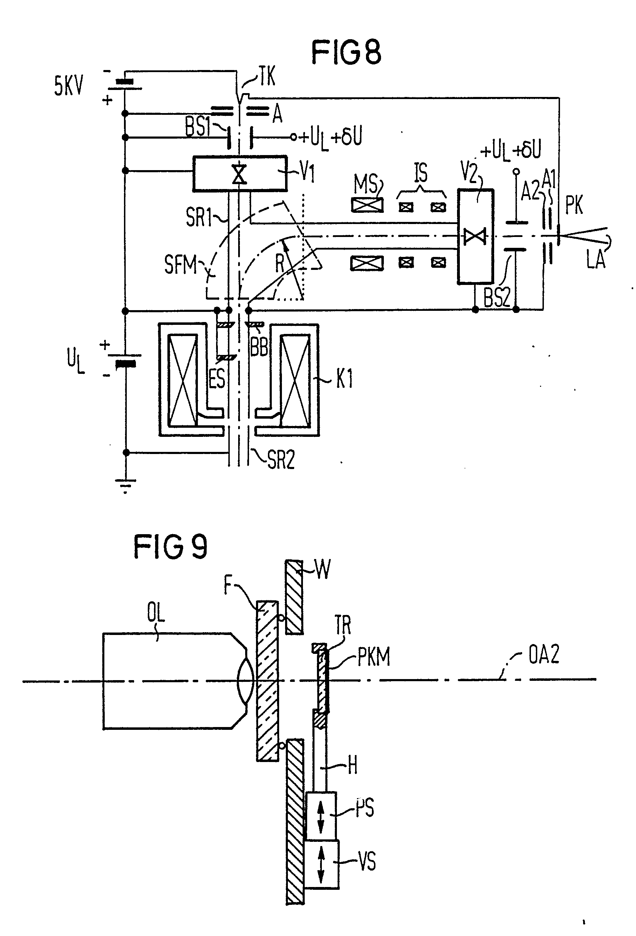

Der Verringerung der Energiebreite der Photoelektronen PH dient die im Zwischenbild $z_{B1}$ der Photoelektronenquelle angeordnete Schneide bzw. Schlitzblende ES. Wie die Figur 8 zeigt, liegt diese energieselektierende Einrichtung ebenso wie das zweite Strahlaustastsystem BS2 (Reduktion der Wiederholrate der Photoelektronenimpulse), die im Strahlengang vor dem Immersionskondensor K1 angeordnete Strahlaustastblende BB, das obere Strahlrohr SR1 und die Ventile V1 bzw. V2 auf Hochspannung, wobei die zwischen den Elektroden SR1 und SR2 der elektrostatischen Zweirohrlinse aufgebaute Potentialdifferenz beispielsweise $U_L = 4$ kV beträgt.

Um die Lebensdauer der Photokathode PH zu verlängern wird vorgeschlagen, den die 100 bis 200 Å dicke Edelmetall- bzw. Alkalimetallschicht PKM tragenden Glaskörper TR in dem durch das Kammerfenster F einfallenden Laserstrahl LA zu bewegen (siehe Figur 9). Als Antriebseinheit dient hierbei ein piezoelektrischer Schwinger PS, der den die Photokathode TR/PKM tragenden Halter H in einer senkrecht zur Strahlachse OA2 liegenden Ebene mit einer Frequenz von beispielsweise 1 kHz periodisch verschiebt. Ist das Photokathodenmaterial PKM in dem vom Laserstrahl LA ausgeleuchteten Bereich aufgebraucht, wird die ebenfalls piezoelektrische Verstellung VE aktiviert, um den Glasträger TR und den piezoelektrischen Schwinger PS in der durch den Pfeil angegebenen Richtung zu verschieben.

Die Erfindung ist selbstverständlich nicht auf die beschriebenen Ausführungsbeispiele beschränkt. So ist es ohne weiteres möglich, das homogene magnetische Sektorfeld mit einer quellenseitig geneigten Feldbegrenzungsebene (schräger Strahleintritt) durch ein inhomogenes magnetisches Sektorfeld mit einem Feldgradienten mit Feldindex n = 1/2 zu ersetzen.

## Ansprüche

1. Elektronenstrahlmeßgerät mit einer auf einer ersten Strahlachse (OA1) angeordneten ersten Elektronenquelle (TK), einem ersten Strahlaustastsystem (BS1), einer Strahlaustastblende (BB), mindestens einer Kondensorlinse (K1, K2), einer Objektivlinse (SO) zur Fokussierung der entlang der ersten Strahlachse (OA1) geführten Elektronen (PE) auf eine Probe (IC) und einem Spektrometer-Detektorsystem (SO, DT) zum Nachweis der auf der Probe (IC) aufgelösten sekundären und rückgestreuten Teilchen, **gekennzeichnet durch** eine auf einer zweiten Strahlachse (OA2) angeordneten zweiten Elektronenquelle und eine fokussierende Ablenkeinheit (SFM) zur stigmatischen Abbildung der zweiten Elektronenquelle in ein auf der ersten Strahlachse (OA1) liegen des Zwischenbild ($z_{B1}$).

2. Elektronenstrahlmeßgerät nach Anspruch 1, **dadurch gekennzeichnet,** daß die zweite Elektronenquelle eine von einem Laserstrahl (LA) beaufschlagte Photokathode (PK) aufweist.

3. Elektronenstrahlmeßgerät nach Anspruch 1 oder 2, **dadurch gekennzeichnet,** daß das Ablenkelement (SFM) zwischen der ersten Elektronenquelle (TK) und der Kondensorlinse (K1) angeordnet ist.

4. Elektronenstrahlmeßgerät nach einem der Ansprüche 1 bis 3, **gekennzeichnet durch** einen Sektorfeldmagneten (SFM) als Ablenkelement.

5. Elektronenstrahlmeßgerät nach Anspruch 4, **dadurch gekennzeichnet,** daß der Sektorfeldmagnet (SFM) eine Erregerspule (ES), einen oberen (OP) und einen unteren Polschuh (UP) aufweist, wobei die Polschuhe (OP, UP) derart geformt sind, daß eine erste Normale auf der quellenseitigen Feldbegrenzungsebene einen Winkel $\epsilon_1 > 0$ mit der zweiten Strahlachse (OA2) einschließt.

6. Elektronenstrahlmeßgerät nach Anspruch 5, **gekenn zeichnet durch** eine im Zwischenbild ($z_{B1}$) angeordnete Einrichtung (EZ1, EZ2) zur Korrektur der Verzeichnung des Sektorfeldmagneten (SFM).

7. Elektronenstrahlmeßgerät nach Anspruch 6, **gekennzeichnet durch** ein ein magnetisches Quadrupolfeld erzeugendes Vier- oder Sechspolelement (EZ1, EZ2) als Einrichtung zur Korrektur der Verzeichnung.

8. Elektronenstrahlmeßgerät nach Anspruch 5, **gekennzeichnet durch** eine Linse (OL) zur Fokussierung des Laserstrahls (LA) auf die Photokathode (PK) und eine im lichtoptischen Strahlengang vor der Linse (OL) angeordnete Zylinderlinse (ZL).

9. Elektronenstrahlmeßgerät nach Anspruch 5, **dadurch gekennzeichnet,** daß der Laserstrahl (LA) entlang einer dritten Strahlachse geführt wird, wobei die dritte Strahlachse einen Winkel mit der zweiten Strahlachse (OA2) einschließt.

10. Elektronenstrahlmeßgerät nach Anspruch 5, **dadurch gekennzeichnet,** daß die Polschuhe (OP, UP) derart geformt sind, daß eine zweite Normale auf der probenseitigen Feldbegrenzungsebene einen Winkel $\epsilon_2 > 0$ mit der ersten Strahlachse (OA1) einschließt.

11. Elektronenstrahlmeßgerät nach einem der Ansprüche 1 bis 10, **gekennzeichnet durch** eine im Zwischenbild ($z_{B1}$) angeordnete Blende oder Schneide (ES).

12. Elektronenstrahlmeßerät nach einem der Ansprüche 1 bis 11, **gekennzeichnet durch** einen im Strahlengang vor dem Ablenkelement (SFM) angeordneten magnetischen Hexapolkorrektor (MS).

13. Elektronenstrahlmeßgerät nach einem der Ansprüche 1 bis 12, **gekennzeichnet durch** eine im Strahlengang vor dem Ablenkelement (SFM) angeordnete Aperturblende (AB).

14. Elektronenstrahlmeßgerät nach einem der Ansprüche 1 bis 13, **gekennzeichnet durch** ein im Strahlengang vor dem Ablenkelement (SFM) angeordnetes, zweistufiges magnetisches Justiersystem (JS).

15. Elektronenstrahlmeßgerät nach einem der Ansprüche 1 bis 14, **gekennzeichnet durch** ein im Strahlengang vor dem Ablenkelement (SFM) angeordnetes zweites Strahlaustastsystem (BS2).

16. Elektronenstrahlmeßgerät nach einem der Ansprüche 1 bis 15, **dadurch gekennzeichnet,** daß die Strahlaustastblende (BB) im Strahlengang vor dem Zwischenbild ($z_{B1}$) angeordnet ist.

17. Elektronenstrahlmeßgerät nach einem der Ansprüche 1 bis 16, **dadurch gekennzeichnet,** daß die Photokathode (PK) auf einem Träger (TR) und dieser auf einem von einem Schwinger (PS) bewegten Halter (H) angeordnet ist.

18. Elektronenstrahlmeßgerät nach einem der Ansprüche 1 bis 17, **dadurch gekennzeichnet,** daß die erste (OA1) und die zweite Strahlachse (OA2) einen Winkel von 90° einschließen.

# FIG 1

# FIG 2

# FIG 3

# FIG 4

# FIG 5

# FIG 6

# FIG 7

# FIG 8

# FIG 9